(19) **Europäisches Patentamt**
**European Patent Office**
**Office européen des brevets**

(11) **EP 4 607 227 A1**

(12) **EUROPEAN PATENT APPLICATION**

(43) Date of publication:
**27.08.2025  Bulletin 2025/35**

(21) Application number: **24159015.7**

(22) Date of filing: **22.02.2024**

(51) International Patent Classification (IPC):
*G01R 33/54* (2006.01)   *G01R 33/565* (2006.01)
*G06N 3/02* (2006.01)

(52) Cooperative Patent Classification (CPC):
**G01R 33/543; G01R 33/56563; G01R 33/56572;**
**G06N 3/02; G06N 3/045; G06N 3/084**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
- **Comaniciu, Dorin**
  **Princeton, 08540 (US)**
- **Gall, Peter**
  **91080 Uttenreuth (DE)**
- **Grodzki, David**
  **91058 Erlangen (DE)**

- **Gühring, Jens**
  **91052 Erlangen (DE)**
- **Mailhe, Boris**
  **Plainsboro, 08536 (US)**
- **Nadar, Mariappan S.**
  **Plainsboro, 08536 (US)**
- **Schneider, Rainer**
  **91315 Höchstadt (DE)**
- **Schröter, Steffen**
  **90763 Fürth (DE)**
- **Speckner, Thorsten**
  **91058 Erlangen (DE)**
- **Tamersoy, Birgi**
  **91052 Erlangen (DE)**

(74) Representative: **Siemens Healthineers**
**Patent Attorneys**
**Postfach 22 16 34**
**80506 München (DE)**

(54) **DETERMINING A CONFIGURATION FOR MAGNETIC RESONANCE IMAGING**

(57)     For automatically determining a configuration (25) for magnetic resonance imaging, MRI, an initial scanner model (22) for an MRI scanner (1) is received, the initial scanner model (22) specifying a deviation of a main magnetic field from a predefined target main magnetic field and/or a specifying a deviation of a magnetic field gradient from a predefined target gradient field. MRI measurement data (23) measured by using the MRI scanner (1) is received. A first updated scanner model (24) is generated by applying a trained first machine learning model, MLM, (20) to first input data (22, 23), which depends on the initial scanner model (22) and the MRI measurement data (23). The configuration (25) for MRI is determined depending on the first updated scanner model (24).

FIG 1

**Description**

The present invention is directed to a computer-implemented method for automatically determining a configuration for magnetic resonance imaging, MRI, wherein an initial scanner model for an MRI scanner is received. The invention is further directed to a computer-implemented training method for training a first machine learning model for use in said computer-implemented method for automatically determining a configuration for MRI. The invention is also directed to a corresponding method for MRI using said computer-implemented method for automatically determining a configuration for MRI, to a data processing apparatus and to a computer program product.

MRI is one of the most important tools in medical imaging. In clinical routine imaging however, MRI commonly generates non-quantitative information like weighted images in contrast, for example, to computed tomography. Furthermore, MRI is usually not reproducible, which is becoming more and more an obstacle.

There are several reasons for the current lack of reproducibility and thus also quantitativity of MRI, which may mainly be classified in two different categories. One are MRI scanner-induced imperfections like static B0-variations, for example with different shim configurations, dynamic B0-variations like eddy currents, especially for higher order eddy currents, variations in determining the center frequency, Maxwell terms during the scan or also effects due to gradient non-linearities, especially for off-center imaging. The other are patient-induced effects like B0-variations due to patients' anatomy, effects on B1+ and B1- like coil loading, g-maps, or patient specific B1-maps, or also limitations of SAR-models concerning body coil reflection factors, coil power loss and others. These factors may lead to a variability in the image quality and contrast and non-quantitative results of MRI and hinder quantification of relaxation parameters, ADC-values and others.

In order to better incorporate these effects, very fast and very accurate adjustment and calibration scans would be required, which are, however, currently not available.

In the publication by O. Ronneberger et al.: "U-Net: Convolutional Networks for Biomedical Image Segmentation" (arXiv:1505.04597), the U-Net architecture is described, a widely used CNN architecture for example for image-to-image tasks, for example for image reconstruction tasks.

ResNet is a popular architecture for residual neural networks, which was introduced in the publication K. He et al.: "Deep Residual Learning for Image Recognition", Proceedings of the IEEE Conference on Computer Vision and Pattern Recognition (CVPR), 2016, pp. 770-778. ResNet models are widely used for deep learning tasks due to their ability to enable the training of very deep neural networks.

In the publication R. Rombach et al.: "High-resolution image synthesis with latent diffusion models.", Proceedings of the IEEE/CVF conference on computer vision and pattern recognition (2022), the authors present the application of latent diffusion models for text-guided image synthesis.

In the publication A. Radford et al.: "Learning transferable visual models from natural language supervision.", International conference on machine learning, PMLR (2021), the authors describe CLIP, a neural network architecture, which jointly trains an image encoder and a text encoder to predict the correct pairings of a batch of (image, text) training examples.

In the publication R. Chen et al.: "Neural ordinary differential equations.", Advances in neural information processing systems 31 (2018), the authors describe a deep neural network architecture denotes as NODE, wherein, instead of specifying a discrete sequence of hidden layers, the derivative of the hidden state is parameterized using a neural network.

The publications K. O'Brien et al.: "3-D Residual Eddy Current Field Characterisation: Applied to Diffusion Weighted Magnetic Resonance Imaging", IEEE Transactions on Medical Imaging, vol. 32, no. 8, pp. 1515-1525, and N. G. Lee et al.: "MaxGIRF: Image reconstruction incorporating concomitant field and gradient impulse response function effects", Magnetic Resonance in Medicine, vol. 88, 2, pp. 691-710, describe physics-based corrections methods for image reconstruction in MRI.

It is an objective of the present invention, to mitigate the impact of MRI scanner-induced imperfections and/or patient-induced effects in MRI.

This objective is achieved by the respective subject matter of the independent claims. Further implementations and preferred embodiments are a subject matter of the dependent claims.

The invention is based on the idea, to update an initial scanner model for the MRI scanner based on actual MRI measurement data by using a machine learning model, MLM, which takes the initial scanner model and the MRI measurement data as inputs and predicts the updated scanner model, which is then used to determine a configuration for MRI.

According to an aspect of the invention, a computer-implemented method for automatically determining a configuration for MRI is provided. Therein, an initial scanner model for an MRI scanner is received. The initial scanner model specifies a deviation of a main magnetic field from a predefined target main magnetic field, in particular as a function of the spatial position, and/or the initial scanner model specifies a deviation of a magnetic field gradient from a predefined target gradient field, in particular as a function of the spatial position. MRI measurement data measured by using the MRI scanner is received, in particular from the MRI scanner. A first updated scanner model is generated by applying a trained first MLM to first input data, which depends on, for example comprises, the initial scanner model and the MRI measurement data. The configuration for MRI is determined depending on the first updated scanner model.

Unless stated otherwise, all steps of the computer-implemented method may be performed by a data processing apparatus, which comprises at least one computing unit. In particular, the at least one computing unit is configured or adapted to perform the steps of the computer-implemented method. For this purpose, the at least one computing unit may for example store a computer program comprising instructions which, when executed by the at least one computing unit, cause the at least one computing unit to execute the computer-implemented method. The expressions "data processing apparatus" and "at least one computing unit" may be used interchangeably, here and in the following. This holds also for respective expressions derived therefrom.

In case the at least one computing unit comprises two or more computing units, certain steps carried out by the at least one computing unit may also be understood such that different computing units carry out different steps or different parts of a step. In particular, it is not required that each computing unit carries out the steps. In other words, carrying out the steps may be distributed amongst the two or more computing units.

From each implementation of the computer-implemented method, a respective implementation of a method for method for automatically determining a configuration for MRI, which is not purely computer-implemented, is obtained by including respective steps of generating the MRI measurement data, in particular by an MRI system comprising the MRI scanner.

In general terms, a trained MLM may mimic cognitive functions that humans associate with other human minds. In particular, by training based on training data the MLM may be able to adapt to new circumstances and to detect and extrapolate patterns. Another term for a trained MLM is "trained function".

In general, parameters of an MLM can be adapted or updated by means of training. In particular, supervised training, semi-supervised training, unsupervised training, reinforcement learning and/or active learning can be used. Furthermore, representation learning, also denoted as feature learning, can be used. In particular, the parameters of the MLMs can be adapted iteratively by several steps of training. In particular, within the training a certain loss function, also denoted as cost function, can be minimized. In particular, within the training of an artificial neural network, ANN, the backpropagation algorithm can be used.

In particular, an MLM can comprise an ANN, a support vector machine, a decision tree and/or a Bayesian network, and/or the MLM can be based on k-means clustering, Q-learning, genetic algorithms and/or association rules. In particular, an ANN can be or comprise a deep neural network, a convolutional neural network or a convolutional deep neural network. Furthermore, an ANN can be an adversarial network, a deep adversarial network and/or a generative adversarial network.

In the present context, the first MLM has been trained to predict an updated scanner model, in particular the first updated scanner model, from input data comprising at least a present scanner model, in particular the initial scanner model, and MRI measurement data. The training may be carried out in different ways including, for example, unsupervised training approaches. For example, a training scanner model and training MRI data may be provided and noise is added to the training scanner model. The first MLM may then be trained to reconstruct the training scanner model from the noisy training scanner model and the training MRI data.

The output of the first MLM may for example be the first updated scanner model. Alternatively, the output of the first MLM may be a deviation of the first updated scanner model from the initial scanner model. The output of the first MLM may then be combined with, in particular added to, the initial scanner model to generate the first updated scanner model.

In particular, in case the initial scanner model specifies the deviation of the main magnetic field from the target main magnetic field, the updated scanner model also specifies the deviation of the main magnetic field from the target main magnetic field. Analogously, in case the initial scanner model specifies the deviation of the magnetic field gradient from the target gradient field, the updated scanner model also specifies the deviation of the magnetic field gradient from the target gradient field.

The MRI measurement data may be acquired when imaging a patient or a phantom object, for example. The MRI measurement data may also be pre-processed. The MRI measurement data may be corresponding k-space data or may be converted into image space, also denoted as position space, or may be reconstructed MRI images or partially reconstructed MRI images.

The main magnetic field is also denoted by B0. The target main magnetic field may for example be characterized by a constant field strength within a predefined three-dimensional volume of interest, in particular within a bore of the MRI scanner. The deviation of the main magnetic field from the target main magnetic field, also denoted as dB0, may be specified by one or more volumetric maps. A volumetric map may be given by a three-dimensional array or tensor, wherein each entry of the array contains the respective value of dB0 for a corresponding voxel in the volume of interest. The three-dimensional array can analogously be given by a plurality of two-dimensional arrays or matrices, respectively.

Also alternative mathematical formulations are possible, however. The deviation of the main magnetic field from the target main magnetic field may also be provided in terms of one or more respective expansions of dB0 in terms of suitable mathematical basis functions, for example in terms of spherical harmonics or the like. It is also possible that the one or more volumetric maps are pre-processed, in particular compressed, and the deviation of the main magnetic field from the target main magnetic field may then be given in terms of the pre-processed one or more volumetric maps.

The deviation of the main magnetic field from the target main magnetic field may comprise one or more components, wherein each component may, for example, correspond to another physical cause of the deviation. For example, dB0 may be given by {$dB0_1$, $dB0_2$, ...}. $dB0_1$ may for example correspond to deviations due to eddy currents, $dB0_2$ may correspond to deviations due to Maxwell terms, etcetera.

The magnetic field gradient is also denoted by G and refers to the amplitude of the magnetic field gradient. The target gradient field may for example be characterized by one or more predefined spatial profiles within the three-dimensional volume of interest. The one or more spatial profiles may for example be given by a linear profile or by a superposition of two or more linear profiles along different spatial directions. However, also more complex, in particular non-linear profiles may be used. The deviation of the magnetic gradient field from the target gradient field, also denoted as dG, may also be specified by one or more volumetric maps, an expansion in suitable basis functions, or other alternatives as described with respect to dB0.

In particular, the initial scanner model may be given by or contain a corresponding representation of dB0 and/or dG as described as an approximative model for the MRI scanner prior to the measurement of the MRI measurement data. The first updated scanner model may contain the same types of data, in particular said representation of dB0 and/or dG, as an approximative model for the MRI scanner after generating the MRI measurement data.

It is noted that said steps of the computer-implemented method may be repeated at multiple times using different MRI measurement data each time and replacing the initial scanner model by the first updated scanner model or, in some implementations described further below, by a respective second updated scanner model, which depends on the first updated scanner model, in each repetition. In particular, the said steps of the computer-implemented method may be repeated whenever an MRI measurement or a suitable MRI measurement is carried out.

Consequently, it is achieved by the computer-implemented method according to the invention, that always an up-to-date version of the scanner model is available and can be used to determine the current optimal configuration for MRI. Since the first MLM may be trained on very large data basis, an improved accuracy of the first updated scanner model is achieved.

The configuration for MRI determined depending on the first updated scanner model may include acquisition parameters, for example RF shimming parameters, dynamic fat saturation pulses, etcetera, or corrections to the interpretation of acquired measurements, for example geometric distortions due to gradient non-linearities, bias field corrections due to g-factor effects, etcetera, or both, for example a k-space sampling frequency adjustment to achieve a target spatial resolution in regions of gradient non-linearities, et cetera.

The configuration for MRI may for example be determined manually by application specialists depending on the first updated scanner model. Alternatively or in addition, The configuration for MRI may be determined automatically or semiautomatically based on the first updated scanner model using, for example pre-defined rules and/or physics-based correction methods or the like.

According to several implementations, the configuration for MRI comprises respective values for one or more parameters specifying a data acquisition by the MRI scanner.

Consequently, a future data acquisition may be carried out taking into account the current status of the MRI scanner represented by the first updated scanner model in an optimal manner, improving the reproducibility of the MRI results and allowing for an improved quantitative evaluation of the MRI results.

In particular, the one or more parameters specifying the data acquisition by the MRI scanner may, in particular, be determined by human specialists according to the first updated scanner model in order to achieve an optimum image quality, which is, as such, a common practice for MRI.

According to several implementations, the one or more parameters specifying the data acquisition comprises one or more currents for active shimming, and/or one or more parameters defining an application of an RF-pulse, and/or one or more parameters defining a k-space sampling scheme.

According to several implementations, the configuration for MRI comprises data specifying an MRI image reconstruction.

Consequently, a future MRI image reconstruction may be carried out taking into account the current status of the MRI scanner represented by the first updated scanner model in an optimal manner, improving the reproducibility of the MRI results and allowing for an improved quantitative evaluation of the MRI results.

In order to determine the data specifying the MRI image reconstruction based on the first updated scanner model, known physics-based corrections methods, as described, for example, in the publications of K. O'Brien et al. and N. G. Lee et al., respectively, mentioned in the introductory part, may be used. Said publications make use of dedicated calibration measurements, which may for example be replaced with the corresponding date from the first updated scanner model keeping the correction method the same apart from said replacement.

According to several implementations, the data specifying an MRI image reconstruction comprises a correction map for diffusion imaging, in particular an ADC map (ADC: apparent diffusion coefficient), and/or bias field correction data, and/or undistortion data for compensating a potential geometric image distortion, and/or a k-space sampling frequency adjustment.

According to several implementations, a sequence description of an MRI sequence corresponding to the MRI measurement data is received and the first input data depends on, in particular comprises, the sequence description.

The sequence description specifies the MRI acquisition sequence, which has been used to generate the MRI measurement data. The sequence description may for example be provided in text form according to a predefined format, in particular as structured text.

In such implementations, the first MLM has been trained to predict the updated scanner model from input data comprising at least the present scanner model, the MRI measurement data and the sequence description. During training, the first MLM may be trained to reconstruct the training scanner model from the noisy training scanner model, the training MRI data, and a corresponding training sequence description. This allows the first MLM to predict the first updated scanner model in a reliable and accurate manner also for different MRI sequences used to generate the MRI measurement data.

According to several implementations, the first MLM comprises an MRI data encoder module and applying the trained first MLM to the first input data comprises applying the MRI data encoder module to the MRI measurement data to generate encoded MRI measurement data. In particular, the first updated scanner model is generated depending on the encoded MRI measurement data.

In such implementations, the first MLM, in particular the MRI data encoder module, is for example an ANN. The MRI data encoder module may for example comprise a CNN or a residual neural network or a residual CNN.

In such implementations, a design or architecture of the first MLM that fits the data structure of the MRI measurement data particularly well may be used. In particular, the MRI measurement data may be provided in the form of one or more two-dimensional or three-dimensional arrays of data, in particular in the k-space or in the position space or in a hybrid space.

According to several implementations, the first MLM comprises a model encoder module and applying the trained first MLM to the first input data comprises applying the model encoder module to the initial scanner model to generate encoded model data.

In particular, the first updated scanner model is generated depending on the encoded model data, for example depending on the encoded model data and the encoded MRI measurement data.

In such implementations, the first MLM, in particular the model encoder module, is for example an ANN. The model encoder module may for example comprise a CNN or a residual neural network or a residual CNN.

In such implementations, a design or architecture of the first MLM that fits the data structure of the initial scanner model particularly well may be used.

According to several implementations, the first MLM comprises a sequence encoder module and applying the trained first MLM to the first input data comprises applying the sequence encoder module to the sequence description to generate encoded sequence data.

In particular, the first updated scanner model is generated depending on the encoded sequence data, for example depending on the encoded sequence data and the encoded model data and the encoded MRI measurement data.

In such implementations, the first MLM, in particular the sequence encoder module, is for example an ANN. The sequence encoder module may for example comprise a transformer network.

In such implementations, a design or architecture of the first MLM that fits the data structure of the sequence description particularly well may be used.

According to several implementations, a patient model specifying body properties of a patient or a patient population is received and the first input data depends on, in particular comprises, the patient model.

The body properties may for example include an age, gender, height, and/or weight of the patient or patient population. The body properties may also include information regarding implants or other artificial objects in the body of the patient or patient population. The patient model may for example be provided in text form in an unstructured or structured way or in form of a vector with respective numerical entries.

In such implementations, the first updated scanner model and, consequently, the configuration for MRI may be optimally adapted to a target patient or patient population.

According to several implementations, the first MLM comprises a patient data encoder module and applying the trained first MLM to the first input data comprises applying the patient data module to the sequence description to generate encoded patient data.

In particular, the first updated scanner model is generated depending on the encoded patient data, for example depending on the encoded patient data and the encoded model data and the encoded MRI measurement data and, optionally, on the encoded sequence data.

In such implementations, the first MLM, in particular the patient data encoder module, is for example an ANN. The patient data encoder module may for example comprise a transformer network, in particular in case the patient model is given in text form, or, in particular in case the patient model is given as vector with numerical entries, a fully connected ANN or a multilayer perceptron ANN.

In such implementations, a design or architecture of the first MLM that fits the data structure of the patient model particularly well may be used.

According to several implementations fused data is generated by fusing at least the encoded MRI measurement data and the encoded model data, for example by fusing at least the encoded MRI measurement data and the encoded model data and, optionally, the encoded sequence data and, also optionally, the encoded patient data. In particular, the first updated scanner model is generated depending on the fused data.

In particular, the encoded MRI measurement data and the encoded model data and, if applicable, the encoded sequence data, are generated by the respective encoder modules such that they all have matching dimensions. For example, the respective encoded data may be generated as respective feature maps, each feature map being given by C two-dimensional arrays of size HxW or by a three-dimensional array of size HxWxC, respectively. The dimensions H and W are for example the same for each encoder module, while the channel dimension C may differ or be the same for different encoder modules.

In such implementations, the multimodal input data to the first MLM is fused after encoding the data from the different modalities individually. This allows for a comprehensive consideration of the data from all modalities to predict the first updated scanner model.

The fused data may for example be generated by a fusion module of the first MLM. The fused data may for example be generated by using a known fusion mechanism, for example concatenation or more complex mechanisms.

According to several implementations, the fused data is generated by using cross-attention fusion and/or the fusion module is a cross-attention module.

Consequently, different levels of importance or relevance of the individual encoded datasets may be exploited in a particularly efficient way.

According to several implementations, a second updated scanner model is generated depending on the first updated scanner model and/or depending on the initial scanner model by using an estimation model for predicting a temporal state change of the MRI scanner. The configuration for MRI or a further configuration for MRI is determined depending on the second updated scanner model.

In particular, the estimation model is used to predict the temporal state change of the MRI scanner depending on the first updated scanner model and the second updated scanner model is generated based on the first updated scanner model and the predicted temporal state change. The configuration for MRI is generated based on the second updated scanner model. Alternatively, the configuration for MRI is generated based on the first updated scanner model and the further configuration for MRI is generated based on the second updated scanner model. In this case, the configuration for MRI may be used for MRI until the further configuration for MRI is available and then the further configuration for MRI may be used for MRI.

Alternatively, the estimation model is used to predict the temporal state change of the MRI scanner depending on the initial scanner model and the second updated scanner model is generated based on the initial scanner model and the predicted temporal state change. The configuration for MRI is generated based on the first updated scanner model and the further configuration for MRI is generated based on the second updated scanner model. In this case, the configuration for MRI may be used for MRI until the further configuration for MRI is available and then the further configuration for MRI may be used for MRI.

The estimation model does, in particular, not necessarily require further measured data to predict the temporal state change of the MRI scanner. For example, an a-priori estimation as known from Kalman filter algorithms or related algorithms may be used. Also, a trained second MLM may be used as the estimation model.

The estimation model is adapted or trained to predict the temporal state change of the MRI scanner based on a present scanner model, in particular the first updated scanner model or the initial scanner model. For example, the temporal state change may be linked to a predefined fixed time interval. The estimation model may then predict the temporal state change based on the present scanner model assuming the time interval or approximately the time interval has lapsed since the present scanner model has been generated. It is also possible, however, that the time interval is not fixed but variable.

By using the estimation model, it is achieved that always an up-to-date version of the scanner model is available and can be used to determine the current optimal configuration for MRI, also over periods without acquiring new MRI measurement data. For example, the estimation model and the first MLM may be used as described alternatingly such that, if suitable MRI measurement data are available, the first MLM is applied and otherwise the estimation model is applied.

According to several implementations, using the estimation model comprises applying a trained second MLM to second input data, which depends on the first updated scanner model and/or the initial scanner model. In particular, the estimation model comprises or consists of the trained second MLM.

In such implementations, a particularly reliable prediction of the second updated scanner model is possible.

According to several implementations, the trained second MLM comprises or consists of an ANN, in particular a residual ANN, for example a CNN, in particular a residual CNN, in particular a three-dimensional residual image-to-image CNN.

Such MLMs are particularly efficient and accurate in case the time interval, as described above, is fixed.

According to several implementations the trained second MLM comprises or consists of a neural ordinary differential equation network, also denoted as NODE network.

Such MLMs are particularly efficient and accurate in case the time interval, as described above, is variable. This allows for an improved flexibility when timing the calculation of the second updated scanner model.

According to several implementations, the MRI measurement data comprises patient adjustment scan data and/or patient diagnostic scan data and/or phantom calibration scan data.

According to a further aspect of the invention, a computer-implemented training method for training a first MLM for use in a computer-implemented method for automatically determining a configuration for MRI according to the invention is provided. An initial scanner training model for the MRI scanner is received, the initial training scanner model specifying a deviation of a main magnetic field from a predefined target main magnetic field and/or a specifying a deviation of a magnetic field gradient from a predefined target gradient field. A perturbed scanner model is generated by adding a perturbation to the initial scanner training model. MRI training data measured by using the MRI scanner or obtained by simulating a measurement of the MRI scanner is received. A reconstructed scanner model is generated by applying the first MLM to first input training data, which depends on, in particular comprises, the perturbed scanner model and the MRI training data. The first MLM is updated depending on a value of a predefined loss function, which depends on the initial scanner training model and the reconstructed scanner model, in particular depends on a deviation between the initial scanner training model and the reconstructed scanner model.

Consequently, the first MLM is trained to reconstruct the initial scanner training model. Adding the perturbation may for example comprise adding noise or other artifacts to the initial scanner training model or discarding parts of the initial scanner training model and so forth.

For updating the first MLM, known procedures may be used, such as for example backpropagation, in case the first MLM is an ANN.

Unless stated otherwise, all steps of the computer-implemented training method may be performed by a further data processing apparatus, which comprises at least one further computing unit. In particular, the at least one further computing unit is configured or adapted to perform the steps of the computer-implemented training method. For this purpose, the at least one further computing unit may for example store a further computer program comprising instructions which, when executed by the at least one further computing unit, cause the at least one further computing unit to execute the computer-implemented method.

In case the at least one further computing unit comprises two or more further computing units, certain steps carried out by the at least one further computing unit may also be understood such that different further computing units carry out different steps or different parts of a step. In particular, it is not required that each further computing unit carries out the steps. In other words, carrying out the steps may be distributed amongst the two or more further computing units.

According to several implementations of the computer-implemented method for automatically determining a configuration for MRI according to the invention, the first MLM is trained using a computer-implemented training method according to the invention.

In particular, the steps of the computer-implemented training method are comprised by the computer-implemented method for automatically determining a configuration for MRI in this case.

In alternative implementations, the steps of the computer-implemented training method are not part of the computer-implemented method for automatically determining a configuration for MRI.

Above and in the following, the solution according to the invention is described with respect to methods and systems for automatically determining a configuration for MRI as well as with respect to methods and systems for providing a trained first MLM. Features, advantages, or alternative embodiments herein can be assigned to the other claimed objects and vice versa. In other words, claims and embodiments for providing a trained first MLM can be improved with features described or claimed in the context of determining a configuration for MRI. In particular, datasets used in the methods and systems can have the same properties and features as the corresponding datasets used in the methods and systems for providing a trained first MLM, and the trained first MLMs provided by the respective methods and systems can be used in the methods and systems for determining a configuration for MRI.

According to a further aspect of the invention, a method for MRI of an object is provided. Therein, wherein a computer-implemented method for determining a configuration for MRI according to the invention is carried out.

According to several implementations, the MRI scanner is configured according to the determined configuration for MRI. Further MRI measurement data representing the object is generated by using the configured MRI scanner. An MRI image of the object is reconstructed based on the further MRI measurement data.

Therein, the configuration for MRI comprises, in particular, the one or more parameters specifying a data acquisition.

According to several implementations, further MRI measurement data representing the object is generated by using the MRI scanner. An MRI image of the object is reconstructed based on the further MRI measurement data according to the determined configuration for MRI.

Therein, the configuration for MRI comprises, in particular, the data specifying an MRI image reconstruction.

In case the configuration for MRI comprises the data specifying an MRI image reconstruction and the one or more parameters specifying a data acquisition, said implementations of the method for MRI may also be combined.

Further implementations of the method for MRI according to the invention follow directly from the various embodiments of the computer-implemented method for determining a configuration for MRI according to the invention and vice versa. In particular, individual features and corresponding explanations as well as advantages relating to the various implementations of the computer-implemented method for determining a configuration for MRI according to the invention can be transferred analogously to corresponding implementations of the method for MRI according to the invention.

According to a further aspect of the invention, a data processing apparatus comprising at least one computing unit is provided. The at least one computing unit is adapted to carry out a computer-implemented method for determining a configuration for MRI according to the invention.

In the present disclosure, the expressions "data processing apparatus" and "at least one computing unit" may be used interchangeably. A computing unit may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, a further data processing apparatus comprising at least one further computing unit is provided. The at least one further computing unit is adapted to carry out a computer-implemented training method according to the invention.

According to a further aspect of the invention, an MRI system comprising an MRI scanner and a data processing apparatus according to the invention is provided.

Above and in the following, the solution according to the invention is described with respect to the claimed systems as well as with respect to the claimed methods. Features, advantages, or alternative embodiments herein can be assigned to the other claimed objects and vice versa. In other words, claims and embodiments for the systems can be improved with features described or claimed in the context of the respective methods. In this case, the functional features of the method are implemented by physical units of the system.

According to a further aspect of the invention, a computer program comprising instructions is provided. When the instructions are executed by at least one computing unit, the instructions cause the at least one computing unit to carry out a computer-implemented method for determining a configuration for MRI according to the invention.

The instructions may be provided as program code, for example. The program code can for example be provided as binary code or assembler and/or as source code of a programming language, for example C, and/or as program script, for example Python.

According to a further aspect of the invention, a further computer program comprising further instructions is provided. When the further instructions are executed by at least one further computing unit, the further instructions cause the at least one further computing unit to carry out a computer-implemented training method according to the invention.

The further instructions may be provided as program code, for example. The program code can for example be provided as binary code or assembler and/or as source code of a programming language, for example C, and/or as program script, for example Python.

According to a further aspect of the invention, a computer-readable storage medium storing a computer program according to the invention and/or a further computer program according to the invention is provided.

The computer program, the further computer program and the computer-readable storage medium are respective computer program products comprising the instructions and/or the further instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1    shows schematically an exemplary implementation of an MRI system according to the invention;

FIG 2    shows a schematic flow diagram of an exemplary implementation of a computer-implemented method for automatically determining a configuration for MRI according to the invention;

FIG 3    shows a schematic flow diagram of a further exemplary implementation of a computer-implemented method for automatically determining a configuration for MRI according to the invention;

FIG 4    shows as schematic block diagram of a first MLM for use in a further exemplary implementation of a computer-implemented method for automatically determining a configuration for MRI according to the invention;

FIG 5    shows as schematic block diagram of a first MLM for use in a further exemplary implementation of a computer-implemented method for automatically determining a configuration for MRI according to the invention;

FIG 6    shows schematically an exemplary implementation of an artificial neural network;

FIG 7    shows schematically an exemplary implementation of a convolutional neural network; and

FIG 8    shows schematically an exemplary implementation of a convolutional neural network with a U-Net structure.

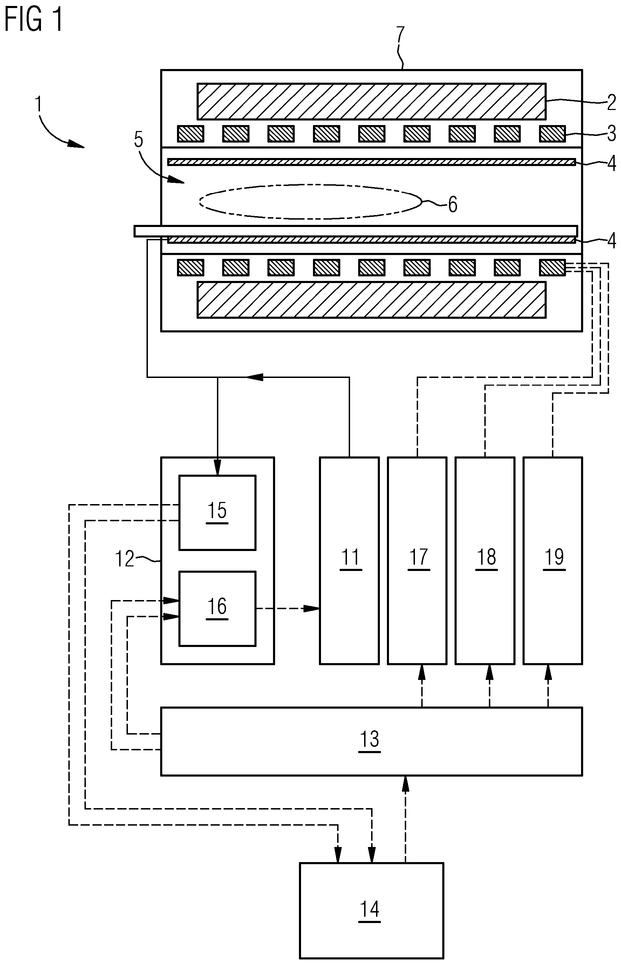

FIG 1 shows schematically an exemplary implementation of an MRI scanner 1, also denoted as MRI system, according to the invention. The MRI system 1 comprises a housing 7 defining a bore 5 and a main magnet arrangement 2, which is configured to generate a main magnetic field, also denoted as polarizing magnetic field, within the bore 5. The MRI system 1 comprises an RF system 4, 11, 12, which is configured to apply an asymmetric RF pulse to a target material, in particular a body part of a patient 6, disposed within the bore 5 and to receive MR signals from the target material. For example, the main magnet arrangement 2 may generate a uniform main magnetic field B0 as the main magnetic field and at least one RF coil 4 of the RF system 4, 11, 12 may emit an excitation field B1. The MRI system 1 comprises a data processing apparatus with at least one computing unit 13, 14, which is configured computer-implemented method for automatically determining a configuration for MRI according to the present invention.

According to MR techniques, the target material is subjected to the main magnetic field, causing the nuclear spins in the target material to precess about the main magnetic field at their characteristic Larmor frequency. A net magnetic moment Mz is produced in the direction z of the main magnetic field, and the randomly oriented magnetic moments of the nuclear spins cancel out one another in the x-y-plane.

When the target material is then subjected to the transmit RF magnetic field, which is for example in the x-y plane and near the Larmor frequency, the net magnetic moment rotates out of the z-direction generating a net in-plane magnetic moment, which rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 15 of an RF controller 12 of the RF system 4, 11, 12, and processed by at least one processor 14 of the at least one computing unit 13, 14 to reconstruct an MR image using for example a known reconstruction technique.

In particular, gradient coils 3 of the MRI system 1 may produce magnetic field gradients Gx, Gy, and Gz for position-encoding of the MR signals. Accordingly, MR signals are emitted only by such nuclei of the target material, which correspond to the particular Larmor frequency. For example, Gz is used together with a bandwidth-limited RF pulse to select a slice perpendicular to the z-direction and consequently may also be denoted as slice selection gradient. In alternative example, Gx, Gy, and Gz may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by the sequence controller 13 to generate respective gradient pulses at predefined time instances.

It is noted that the components of the MRI system 1 can also be arranged differently from the arrangement shown in FIG 1. For example, the gradient coils 3 may be arranged inside the bore 5, similar as shown for the at least one RF coil 4.

A sequence controller 13 of the at least one computing unit 13, 14 may control the generation of RF pulses by an emitter channel 16 of the RF controller 12 and an RF power amplifier 11 of the RF system 4, 11, 12.

The least one processor 14 may receive the real and imaginary parts from analog-digital converters of the receiver channel 15 and reconstruct the MR image based on them according to a known technique.

It is noted that each component of the MRI system 1 may include other elements which are required for the operation thereof, and/or additional elements for providing functions other than those described in the present disclosure.

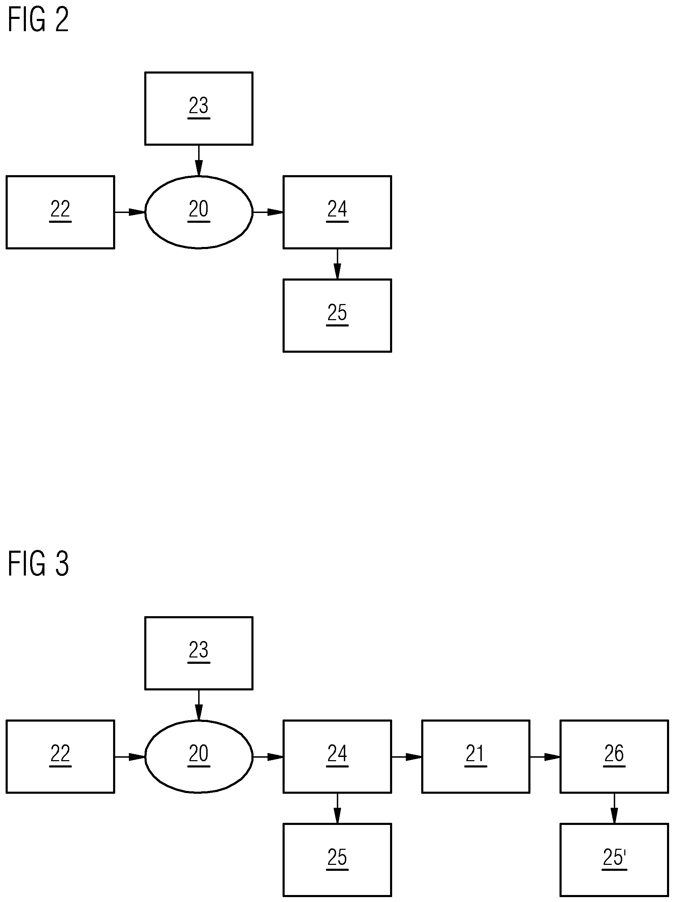

FIG 2 shows a schematic flow diagram of an exemplary implementation of a computer-implemented method for automatically determining a configuration for MRI according to the invention.

Therein, an initial scanner model 22 for the MRI scanner 1 is received, the initial scanner model 22 specifying a deviation of a main magnetic field from a predefined target main magnetic field and/or a specifying a deviation of a magnetic field gradient from a predefined target gradient field. MRI measurement data 23 measured by using the MRI scanner 1 is received. A first updated scanner model 24 is generated by applying a trained first MLM 20 to first input data, which depends on the initial scanner model 22 and the MRI measurement data 23. The configuration 25 for MRI is determined depending on the first updated scanner model 24.

The configuration 25 for MRI determined depending on the first updated scanner model 24 may include acquisition parameters, for example RF shimming parameters, dynamic fat saturation pulses, etcetera, or corrections to the interpretation of acquired measurements, for example geometric distortions due to gradient non-linearities, bias field corrections due to g-factor effects, etcetera, or both, for example a k-space sampling frequency adjustment to achieve a target spatial resolution in regions of gradient non-linearities, et cetera. The MRI scanner 1 may therefore be configured according to the configuration 25 to acquire further MRI measurement data and/or the MRI image reconstruction may be carried out based on the configuration 25.

FIG 3 shows a schematic flow diagram of a further exemplary implementation of a computer-implemented method for automatically determining a configuration for MRI according to the invention, which is based on the implementation of FIG 2.

Therein, a second updated scanner model 26 is generated depending on the first updated scanner model 24 and/or depending on the initial scanner model 22 by applying a trained second MLM 21 to second input data, which depends on the first updated scanner model 24. A further configuration 25' for MRI is determined depending on the second updated scanner model 26, analogously as described for the configuration 25 and the first updated scanner model 24.

In order to qualitatively compensate the effects of scanner-induced imperfections and/or patient-induced effects, a collection of individual calibration and tune-up scans could be performed, for example initial and static tune-up measurements with the MRI scanner's 1 installation trying to capture site specific and system specific factors, for example including shimming parameters, center frequency of the main magnet arrangement 2, and/or low order eddy current fits, as well as dedicated and separate acquisitions for calibrating individual factors of the field generating unit in combination with each patient, such as Tx adjustments (transmitter and frequency) to match the local maximum, dynamic B0 shims by fast and low-resolution mapping acquisitions, optional B1 maps to finetune the phases and/or amplitudes of transmit pulses, and so forth.

These measures would be performed individually and thus result only in a point-wise optimization. Furthermore, the acquisitions may trimmed for speed and low impact on the work-flow and typically consist of only low-resolution acquisitions. Those could subsequently be used to, for example, optimize dynamic RF pulses and/or reconstructions. This "point-wise isolated" approach is, however, in general neither reproducible nor accurate across different scans and/or different systems.

In several implementations, the present invention improves the quality of all deviation measurements by keeping track of observed deviations between patients and by using the first MLM 20 and, optionally, the second MLM 21 to optimize the acquisition based the on interpretation of calibration measurements. A persistent digital representation of all relevant hardware imperfections may therefore be tracked in the form of the scanner model.

In several implementations, every time a patient gets positioned in the MRI scanner 1, calibration measurements are acquired and used to update said scanner model. The scanner model may contain information both about typical values of the imperfections and the uncertainty of those values.

In some implementations, when performing a clinical scan, the current scanner model is used to adapt either acquisition parameters, for example for RF shimming, dynamic fat saturation pulses, etcetera, to correct the interpretation of the acquired measurements, for example geometric distortion due to gradient non-linearities, bias field correction due to g-factor effect, and so forth, or both, for example by adjusting a k-space sampling frequency to achieve a target spatial resolution in regions of gradient non-linearities, etcetera.

The first MLM 20 may be considered as a model update system, which is, in some implementations, trained to incorporate new MRI measurements into the scanner model. The first MLM 20 accepts the previous scanner model and the new MRI measurements as inputs and outputs a new scanner model compatible with the new MRI measurements.

In some implementations, changes to the scanner model may be minimized.

In some implementations, the scanner model is kept constant between patients and is only updated when new calibration MRI measurements are acquired. In other implementations, the second MLM 21 is used to predict the evolution of the scanner model even in the absence of new measurements.

In some implementations, the second MLM 21 accepts the previous scanner model and, for example, a target time interval as inputs and outputs the updated scanner model after the target time interval has passed.

In some implementations, the second MLM 21 is be trained to learn the different time scales of variations between system-specific factors and patient-specific factors, the variations in temporal stability between different scanner models, the impact of anatomical and patient preparation variability in the target population, and so forth.

In some implementations, the MRI measurement data 23 passed to the first MLM 20 comprise data, which are acquired with imaging sequences currently in use for the MRI scanner 1. Suitable data include but are not restricted to patient adjustment scans, patient diagnostic scans and phantom scans performed as part of routine quality control.

In some implementations, a third MLM, which may be denoted as adjustment protocol system, is trained to request which calibration measurements should be acquired for each patient. The third MLM may be trained to acquire necessary information as fast as possible. The measurements can be highly accelerated and completed by the prior information present in the scanner model.

In some implementations, the scanner model is a physical model of quantitative parameters, for example field maps, and correction methods are developed independently of the computation of the scanner model itself. In that case, pre-existing correction methods can be leveraged.

In some implementations, the scanner model comprises correction terms, for example controls for the RF shimming coils.

In some implementations, information extracted from the scanner model is logged periodically and used for long-term device monitoring, for example in order to schedule service visits, to plan component replacements, and so forth.

In some implementations, the scanner model and the associated uncertainty values are utilized for correction measures and methods in system settings, sequence design and reconstruction methods. Shim currents, transmitter voltage and frequencies can be optimally set with respect to patient and system reproducibility. The scanner model allows patient and/or system stable adaptive RF pulse design considering potential deviations in B0 and B1+ fidelity, image reconstruction correction measures, for example in multi-frequency reconstructions, ADC map corrections, bias-field corrections and so forth.

In several implementations, the proposed approach maintains a representation of the MRI scanner 1 over time instead of restarting adjustment scans from scratch for every patient. This allows corrections to be performed based on fewer adjustment measurements for each patient. This has several practical implications including, for example, that the scanner model can be updated using patient diagnostic measurement without requiring additional scan time. Moreover, more imperfections can be corrected, including contrast variations that may cause poor reproducibility in MRI. Furthermore, when dedicated adjustment scans are required, they can be further accelerated.

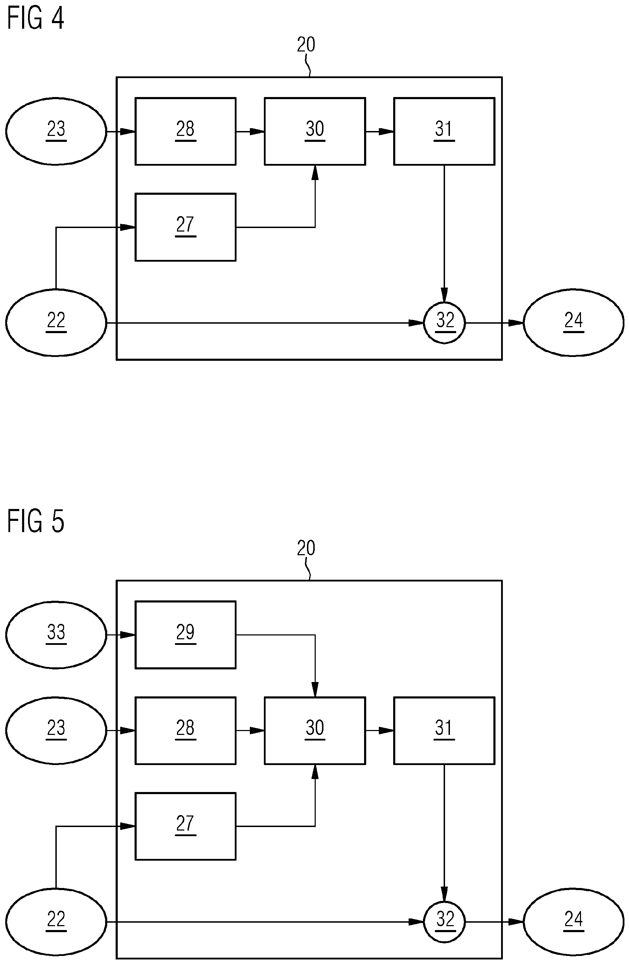

FIG 4 shows as schematic block diagram of a first MLM 20 for use in a further exemplary implementation of a computer-implemented method for automatically determining a configuration for MRI according to the invention.

In this implementation, the first MLM 20 comprises a model encoder module 27 and MRI data encoder module 28. Applying the trained first MLM 20 to the first input data comprises applying the model encoder module 27 to the initial scanner model 22 and applying the MRI data encoder module 28 to the MRI measurement data 23. The output of the model encoder module 27 is encoded model data and the output of the MRI data encoder module 28 is encoded MRI measurement data.

Fused data is generated by a cross-attention fusion module 30 of the first MLM 20 by fusing at least the encoded MRI measurement data and the encoded model data. The first MLM 20 further comprises a model decoder module 31 and the first updated scanner model 24 is generated by applying the model decoder module 31 to the fused data. Therein, the output of the model decoder module 31 may contain corrections to the initial scanner model 22, which may be made to the initial scanner model 22 by a correction module 32 to generate the first updated scanner model 24.

FIG 5 shows as schematic block diagram of a first MLM 20 for use in a further exemplary implementation of a computer-implemented method for automatically determining a configuration for MRI according to the invention, which is based on the implementation of FIG 4.

In this implementation, the first MLM 20 further comprises a sequence encoder module 29, which is applied to a sequence description 33 that specifies the sequence, which was used to generate the MRI measurement data 23. The output of the sequence encoder module 29 is encoded sequence data. The fused data is generated by the cross-attention fusion module 30 of the first MLM 20 by fusing the encoded MRI measurement data, the encoded model data, and the encoded sequence data.

In some implementations, the first MLM 20 is a residual neural network that accepts the initial scanner model and the MRI measurement data 23 as an input and outputs the corrections to the initial scanner model 23 to fit the MRI measurement data 23.

In order to potential accept MR data from a variety of MRI sequences, the first MLM 20 also accepts the sequence description 33. That makes the system multimodal. The MRI sequence may for example be represented in form of structured text, the scanner model can be a set of volumetric maps of field inhomogeneities or a compressed representation thereof, for example an expansion in a basis of spherical harmonics. The MRI measurement data 23 may be given as raw measurements or in terms of reconstructed images.

In some implementations, the first MLM 20 first applies a separate encoder module 27, 28, 29 to each modality to compute a set encoded features for each modality, then fuses the features using the cross-attention fusion module 30, and then the model decoder module 31 receives the fused data as an input and outputs the correction term for the initial scanner model 23. A similar approach is also known in text-guided image synthesis, as mentioned in the introductory part of the present disclosure.

The architecture of each encoder module 27, 28, 29 may be adapted to the data format according to the respective input modality. For example, a CNN may be used for image or volumetric maps, a transformer network may be used for text inputs, a fully connected network may be used for unstructured vectors of parameters, and so forth.

In some implementations, the output data from all encoder module 27, 28, 29 have the same dimensions so that they can be used more easily together in the cross-attention fusion module 30.

In some implementations, the encoder modules 27, 28, 29 can be pretrained in a self-supervised way to maximize the correlation between the different modalities on real measurement data and/or simulated data. For example, a correlation between MRI images and the MRI protocol that generated them may be maximized, similarly to the CLIP method mentioned in the introductory part of the present disclosure. The complete first MLM 20 may then be trained on simulated data by first using a scanner model and MR sequence to simulate MR data, then adding noise to the scanner model, and finally training the first MLM 20 to compute the correction needed to retrieve the original scanner model from the noisy scanner model passed as input.

In some implementations, the second MLM 21 models the temporal evolution of the scanner model in the absence of measurements. As such, it may receive only the current scanner model as an input. In some implementations, the second MLM 21 is called at fixed time intervals and is implemented as a residual neural network. It computes the correction to be added to the current scanner model. The model architecture may be adapted to the representation used for the scanner model. For example, 3D residual image-to-image CNN, which may be based on the U-Net, for example, may be used if the scanner model is represented by volumetric maps. Alternatively, the second MLM 21 is called at variable time intervals, for example at every scan. In this case, the second MLM 21 may for example be implemented as a neural ordinary differential equation, NODE, mentioned in the introductory part of the present disclosure. The second MLM 21 may then accept the current scanner model as an input and output the temporal derivative of the scanner model evolution. Then, the temporal evolution may be computed using a standard numerical method for solving ordinary differential equations, such as the Runge-Kutta method, until the target time is reached.

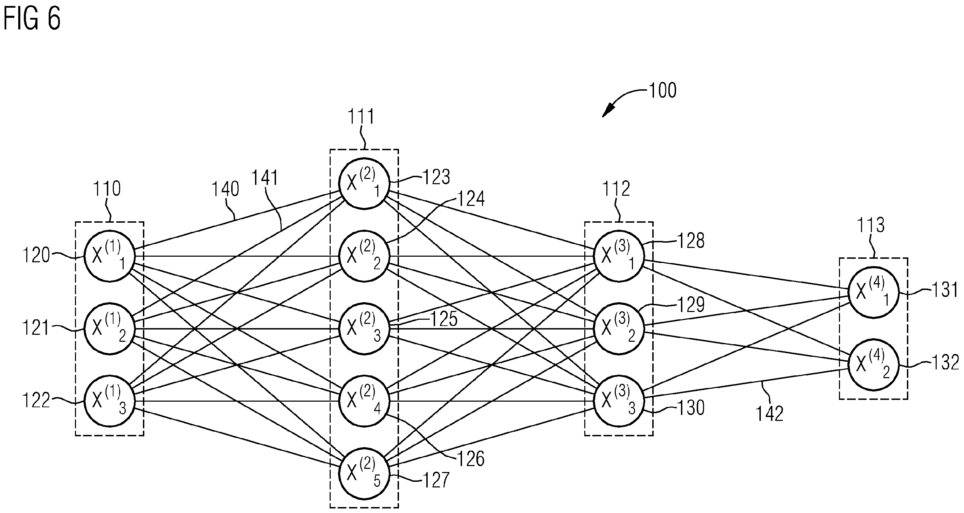

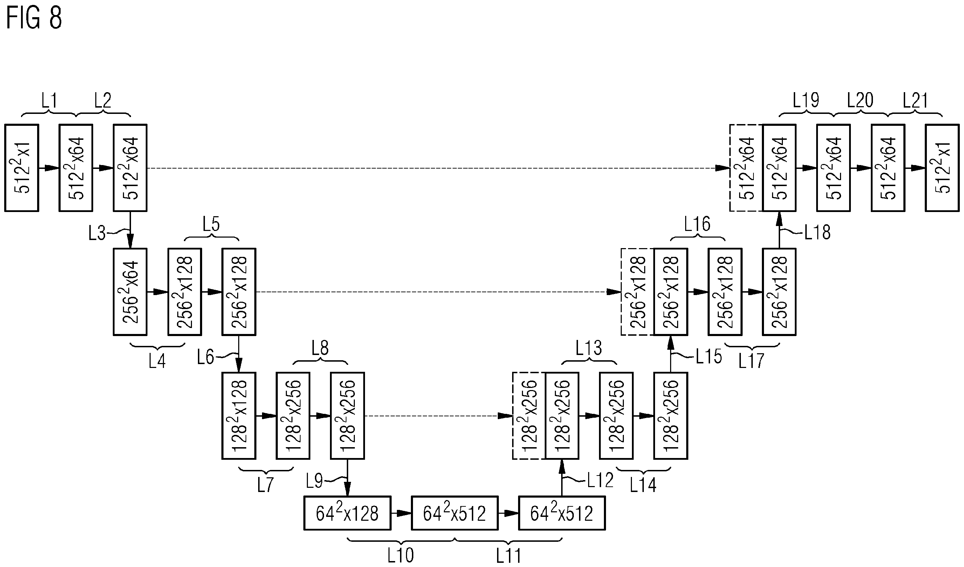

FIG 6 displays an embodiment of an ANN 100, which is for example designed as an MLP. The ANN 100 comprises nodes 120, ..., 132 and edges 140, ..., 142, wherein each edge 140, ..., 142 is a directed connection from a first node 120, ..., 132 to a second node 120, ..., 132. In general, the first node 120, ..., 132 and the second node 120, ..., 132 are different nodes 120, ..., 132. It is, however, also possible that the first node 120, ..., 132 and the second node 120, ..., 132 are identical. For example, in FIG 8, the edge 140 is a directed connection from the node 120 to the node 123, and the edge 142 is a directed connection from the node 130 to the node 132. An edge 140, ..., 142 from a first node 120, ..., 132 to a second node 120, ..., 132 is also denoted as ingoing edge for the second node 120, ..., 132 and as outgoing edge for the first node 120, ..., 132.

In this example, the nodes 120, ..., 132 of the artificial neural network 100 can be arranged in layers 110, ..., 113, wherein the layers can comprise an intrinsic order introduced by the edges 140, ..., 142 between the nodes 120, ..., 132. In particular, edges 140, ..., 142 can exist only between neighboring layers of nodes. In the displayed example, there is an input layer 110 comprising only nodes 120, ..., 122 without an incoming edge, an output layer 113 comprising only nodes 131, 132 without outgoing edges, and hidden layers 111, 112 in-between the input layer 110 and the output layer 113. In general, the number of hidden layers 111, 112 can be chosen arbitrarily. In an MLP, this number is at least one. The number of nodes 120, ..., 122 within the input layer 110 usually relates to the number of input values of the artificial neural network 100, and the number of nodes 131, 132 within the output layer 113 usually relates to the number of output values of the artificial neural network 100.

In particular, a real number can be assigned as a value to every node 120, ..., 132 of the artificial neural network 100. Here, $x^{(n)}_i$ denotes the value of the i-th node 120, ..., 132 of the n-th layer 110, ..., 113. The values of the nodes 120, ..., 122 of the input layer 110 are equivalent to the input values of the artificial neural network 100. The values of the nodes 131, 132 of the output layer 113 are equivalent to the output value of the artificial neural network 100. Furthermore, each edge 140, ..., 142 can comprise a weight being a real number.

In particular, the weight is a real number within the interval [-1, 1] or within the interval [0, 1]. Here, $w^{(m,n)}_{i,j}$ denotes the weight of the edge between the i-th node 120, ..., 132 of the m-th layer 110, ..., 113 and the j-th node 120, ..., 132 of the n-th layer 110, ..., 113. Furthermore, the abbreviation $w^{(n)}_{i,j}$ is defined for the weight $w^{(n,n+1)}_{i,j}$.

In particular, to calculate the output values of the neural network 100, the input values are propagated through the neural network 100. In particular, the values of the nodes 120, ..., 132 of the (n+1)-th layer 110, ..., 113 can be calculated based on the values of the nodes 120, ..., 132 of the n-th layer 110, ..., 113 by

$$x_j^{(n+1)} = f\left(\sum_i x_i^{(n)} \, w_{i,j}^{(n)}\right).$$

Herein, the function f is denoted as transfer function or activation function. Known transfer functions are step functions, the sigmoid functions, for example the logistic function, the generalized logistic function, the hyperbolic tangent, the arctangent function, the error function, the smoothstep function, or rectifier functions. The transfer function is mainly used for normalization purposes.

In particular, the values are propagated layer-wise through the neural network 100, wherein values of the input layer 110 are given by the input of the neural network 100, wherein values of the first hidden layer 111 can be calculated based on the values of the input layer 110 of the neural network 100, wherein values of the second hidden layer 112 can be calculated based in the values of the first hidden layer 111, and so forth.

In order to set the values $w^{(m,n)}_{i,j}$ for the edges, the neural network 100 has to be trained using training data. In particular, training data comprises training input data and training output data (denoted as $t_i$). For a training step, the neural network 100 is applied to the training input data to generate calculated output data. In particular, the training data and the calculated output data comprise a number of values, said number being equal with the number of nodes of the output layer. In particular, a comparison between the calculated output data and the training data is used to recursively adapt the weights within the neural network 100 (backpropagation algorithm). In particular, the weights are changed according to

$$w_{i,j}^{\prime(n)} = w_{i,j}^{(n)} - \gamma \, \delta_j^{(n)} \, x_i^{(n)},$$

wherein $\gamma$ is a predefined learning rate, and the numbers $\delta^{(n)}_j$ can be recursively calculated as

$$\delta_j^{(n)} = \left(\sum_k \delta_k^{(n+1)} \, w_{j,k}^{(n+1)}\right) f'\left(x_i^{(n)} w_{i,j}^{(n)}\right)$$

based on $\delta^{(n+1)}_j$, if the (n+1)-th layer is not the output layer 113, and

$$\delta_j^{(n)} = \left(x_j^{(n+1)} - t_j^{(n+1)}\right) f'\left(x_i^{(n)} w_{i,j}^{(n)}\right),$$

if the (n+1)-th layer is the output layer 113, wherein f' is the first derivative of the activation function, and $t^{(n+1)}_j$ is the comparison training value for the j-th node of the output layer 113.

A CNN is an ANN that uses a convolution operation instead of general matrix multiplication in at least one of its layers. These layers are denoted as convolutional layers. In particular, a convolutional layer performs a dot product of one or more convolution kernels with the convolutional layer's input data, wherein the entries of the one or more convolution kernel are parameters or weights that may be adapted by training. In particular, one can use the Frobenius inner product and the ReLU activation function. A convolutional neural network can comprise additional layers, for example pooling layers, fully connected layers, and/or normalization layers.

By using convolutional neural networks, the input can be processed in a very efficient way because a convolution operation based on different kernels can extract various image features so that by adapting the weights of the convolution kernel the relevant image features can be found during training. Furthermore, based on the weight-sharing in the convolutional kernels fewer parameters need to be trained, which prevents overfitting in the training phase and allows to have faster training or more layers in the network, improving the performance of the network.

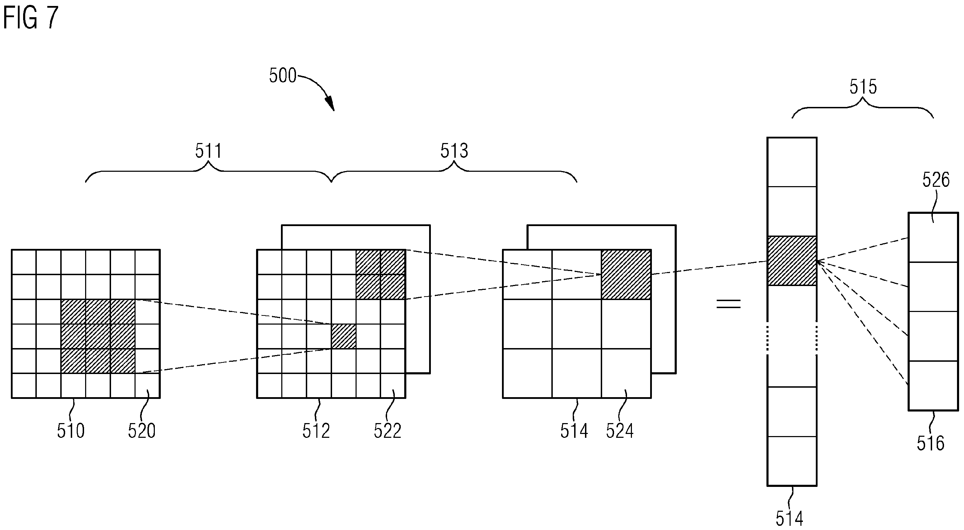

FIG 7 displays an exemplary embodiment of a convolutional neural network 500. In the displayed embodiment, the convolutional neural network 500 comprises an input node layer 510, a convolutional layer 511, a pooling layer 513, a fully connected layer 514 and an output node layer 516, as well as hidden node layers 512, 514. Alternatively, the convolutional neural network 200 can comprise several convolutional layers 511, several pooling layers 513 and/or several fully connected layers 515, as well as other types of layers. The order of the layers can be chosen arbitrarily, usually fully connected layers 515 are used as the last layers before the output layer 516.

In particular, within a convolutional neural network 500 nodes 520, 522, 524 of a node layer 510, 512, 514 can be considered to be arranged as a d-dimensional matrix or as a d-dimensional image. In particular, in the two-dimensional case the value of the node 520, 522, 524 indexed with i and j in the n-th node layer 510, 512, 514 can be denoted as x(n)[i, j]. However, the arrangement of the nodes 520, 522, 524 of one node layer 510, 512, 514 does not have an effect on the calculations executed within the convolutional neural network 500 as such, since these are given solely by the structure and the weights of the edges.

A convolutional layer 511 is a connection layer between an anterior node layer 510 with node values x(n-1) and a posterior node layer 512 with node values x(n). In particular, a convolutional layer 511 is characterized by the structure and the weights of the incoming edges forming a convolution operation based on a certain number of kernels. In particular, the structure and the weights of the edges of the convolutional layer 511 are chosen such that the values x(n) of the nodes 522 of the posterior node layer 512 are calculated as a convolution x(n) = K * x(n-1) based on the values x(n-1) of the nodes 520 anterior node layer 510, where the convolution * is defined in the two-dimensional case as

$$x^{(n)}[i,j] = \left(K * x^{(n-1)}\right)[i,j] = \sum_{i'} \sum_{j'} K[i',j'] \cdot x^{(n-1)}[i-i', j-j'].$$

Herein, the kernel K is a d-dimensional matrix, in the present example a two-dimensional matrix, which is usually small compared to the number of nodes 520, 522, for example a 3x3 matrix, or a 5x5 matrix. In particular, this implies that the weights of the edges in the convolution layer 511 are not independent, but chosen such that they produce said convolution equation. In particular, for a kernel being a 3x3 matrix, there are only 9 independent weights, each entry of the kernel matrix corresponding to one independent weight, irrespectively of the number of nodes 520, 522 in the anterior node layer 510 and the posterior node layer 512.

In general, convolutional neural networks 500 use node layers 510, 512, 514 with a plurality of channels, in particular, due to the use of a plurality of kernels in convolutional layers 511. In those cases, the node layers can be considered as (d+1)-dimensional matrices, the first dimension indexing the channels. The action of a convolutional layer 511 is then in a two-dimensional example defined as

$$x_b^{(n)}[i,j] = \sum_a (K_{a,b} * x_a^{(n-1)}[i,j] = \sum_a \sum_{i'} \sum_{j'} K_{a,b}[i',j'] \cdot x_a^{(n-1)}[i-i', j-j'],$$

wherein $x_a^{(n)}$ corresponds to the a-th channel of the anterior node layer 510, $x_b^{(n)}$ corresponds to the b-th channel of the posterior node layer 512 and $K_{a,b}$ corresponds to one of the kernels. If a convolutional layer 511 acts on an anterior node layer 510 with A channels and outputs a posterior node layer 512 with B channels, there are A·B independent d-dimensional kernels $K_{a,b}$.

In general, in convolutional neural networks 500 activation functions may be used. In this embodiment, ReLU (rectified linear unit) is used, with R(z) = max(0, z), so that the action of the convolutional layer 511 in the two-dimensional example is

$$x_b^{(n)}[i,j] = R\left(\sum_a (K_{a,b} * x_a^{(n-1)}[i,j]\right)$$
$$= R\left(\sum_a \sum_{i'} \sum_{j'} K_{a,b}[i',j'] \cdot x_a^{(n-1)}[i-i', j-j']\right).$$

It is also possible to use other activation functions, for example ELU (exponential linear unit), LeakyReLU, Sigmoid, Tanh or Softmax.

In the displayed embodiment, the input layer 510 comprises 36 nodes 520, arranged as a two-dimensional 6x6 matrix. The first hidden node layer 512 comprises 72 nodes 522, arranged as two two-dimensional 6x6 matrices, each of the two matrices being the result of a convolution of the values of the input layer with a 3x3 kernel within the convolutional layer 511. Equivalently, the nodes 522 of the first hidden node layer 512 can be interpreted as arranged as a three-dimensional 2x6x6 matrix, wherein the first dimension correspond to the channel dimension.

An advantage of using convolutional layers 511 is that spatially local correlation of the input data can exploited by enforcing a local connectivity pattern between nodes of adjacent layers, in particular by each node being connected to only a small region of the nodes of the preceding layer.

A pooling layer 513 is a connection layer between an anterior node layer 512 with node values x(n-1) and a posterior node layer 514 with node values x(n). In particular, a pooling layer 513 can be characterized by the structure and the weights of the edges and the activation function forming a pooling operation based on a non-linear pooling function f. For example, in the two-dimensional case the values x(n) of the nodes 524 of the posterior node layer 514 can be calculated based on the values x(n-1) of the nodes 522 of the anterior node layer 512 as

$$x_b^{(n)}[i,j] = f\left(x_b^{(n-1)}[id_1, jd_2], \dots, \qquad x_b^{(n-1)}[(i+1)d_1 - 1, (j+1)d_2 - 1]\right).$$

In other words, by using a pooling layer 513, the number of nodes 522, 524 can be reduced by re-placing a number $d1 \cdot d2$ of neighboring nodes 522 in the anterior node layer 512 with a single node 522 in the posterior node layer 514 being calculated as a function of the values of said number of neighboring nodes. In particular, the pooling function f can be the max-function, the average or the L2-Norm. In particular, for a pooling layer 513 the weights of the incoming edges are fixed and are not modified by training.

The advantage of using a pooling layer 513 is that the number of nodes 522, 524 and the number of parameters is reduced. This leads to the amount of computation in the network being reduced and to a control of overfitting.

In the displayed embodiment, the pooling layer 513 is a max-pooling layer, replacing four neighboring nodes with only one node, the value being the maximum of the values of the four neighboring nodes. The max-pooling is applied to each d-dimensional matrix of the previous layer. In this embodiment, the max-pooling is applied to each of the two two-dimensional matrices, reducing the number of nodes from 72 to 18.

In general, the last layers of a convolutional neural network 500 may be fully connected layers 515. A fully connected layer 515 is a connection layer between an anterior node layer 514 and a posterior node layer 516. A fully connected layer 513 can be characterized by the fact that a majority, in particular, all edges between nodes 514 of the anterior node layer 514 and the nodes 516 of the posterior node layer are present, and wherein the weight of each of these edges can be adjusted individually.

In this embodiment, the nodes 524 of the anterior node layer 514 of the fully connected layer 515 are displayed both as two-dimensional matrices, and additionally as non-related nodes, indicated as a line of nodes, wherein the number of nodes was reduced for a better presentability. This operation is also denoted as flattening. In this embodiment, the number of nodes 526 in the posterior node layer 516 of the fully connected layer 515 smaller than the number of nodes 524 in the anterior node layer 514. Alternatively, the number of nodes 526 can be equal or larger.

Furthermore, in this embodiment the Softmax activation function is used within the fully connected layer 515. By applying the Softmax function, the sum the values of all nodes 526 of the output layer 516 is 1, and all values of all nodes 526 of the output layer 516 are real numbers between 0 and 1. In particular, if using the convolutional neural network 500 for categorizing input data, the values of the output layer 516 can be interpreted as the probability of the input data falling into one of the different categories.

In particular, convolutional neural networks 500 can be trained based on the backpropagation algorithm. For preventing overfitting, methods of regularization can be used, for example dropout of nodes 520, ..., 524, stochastic pooling, use of artificial data, weight decay based on the L1 or the L2 norm, or max norm constraints.

In the example of FIG 8, the CNN has a U-Net structure. In the displayed example, the input data to the CNN is a two-dimensional medical image comprising 512x512 pixels, every pixel comprising one intensity value. The CNN comprises convolutional layers indicated by solid, horizontal arrows, pooling layers indicating by solid arrows pointing down, and upsampling layers indicated by solid arrows pointing up. The number of the respective nodes is indicated within the boxes. Within the U-Net structure first the input images are downsampled, in particular by decreasing the size of the images and increasing the number of channels. Afterwards they are upsampled, in particular by increasing the size of the images and decreasing the number of channels, to generate a transformed image.

All except the last convolutional layers L1, L2, L4, L5, L.7, L8, L10, L11, L13, L14, L16, L17, L19, L20 use 3x3 kernels with a padding of 1, the ReLU activation function, and a number of filters or convolutional kernels that matches the number of channels of the respective node layers as indicated in FIG 8. The last convolutional layer uses a 1x1 kernel with no padding and the ReLU activation function.

The pooling layers L3, L6, L9 are max-pooling layers, replacing four neighboring nodes with only one node, the value being the maximum of the values of the four neighboring nodes. The upsampling layers L12, L15, L18 are transposed convolution layers with 3x3 kernels and stride 2, which effectively quadruple the number of nodes. The dashed horizontal arrows correspond to concatenation operations, where the output of a convolutional layer L2, L5, L8 of the downsampling branch of the U-Net structure is used as additional inputs for a convolutional layer L13, L16, L19 of the upsampling branch of the U-Net structure. This additional input data is treated as additional channels in the input node layer for the convolutional layer L13, L16, L19 of the upsampling branch.

For training the CNN, a database of 500 first medical images was used, wherein the respective segmentation mask was created based on annotations of expert radiologists. In particular, the experts determined for each of the 500 first medical images a segmentation mask for a structure of interest, where a value if 1 was assigned to pixels corresponding to the structure of interest, and a value of 0 was assigned to pixels not corresponding to the structure of interest. The database was split into training data (320 datasets), validation data (80 datasets) and test data (100 datasets). For training the CNN, the backpropagation algorithm was used based on a binary cross-entropy cost function

$$L(x, y) = \sum_i \sum_j BCE(y[i,j], M(x)[i,j])$$

with

$$BCE(a, b) := -a \log(b)\,(b) - (1 - a) \log(1 - b),$$

wherein x denotes a first medical image, y determines the corresponding segmentation mask created by the expert radiologist, and M(x) denotes the result of applying the CNN to the first input medical image x. Alternatively, one could use other cost functions like weighted binary cross entropy, Focal Loss or Dice Loss.

Based on the validation set of 80 datasets and the corresponding annotations, the best performing machine learning model out of several machine learning models (with different hyperparameters, for example number of layers, size and number of kernels, padding et cetera) was selected. The specificity and the sensitivity were determined based on the test set comprising 100 datasets and the corresponding annotations.

Independent of the grammatical term usage, individuals with male, female or other gender identities are included within the term.

**Claims**

1. Computer-implemented method for automatically determining a configuration (25) for magnetic resonance imaging, MRI, wherein

   - an initial scanner model (22) for an MRI scanner (1) is received, the initial scanner model (22) specifying a deviation of a main magnetic field from a predefined target main magnetic field and/or a specifying a deviation of a magnetic field gradient from a predefined target gradient field;
   - MRI measurement data (23) measured by using the MRI scanner (1) is received;
   - a first updated scanner model (24) is generated by applying a trained first machine learning model, MLM, (20) to first input data (22, 23), which depends on the initial scanner model (22) and the MRI measurement data (23);
   - the configuration (25) for MRI is determined depending on the first updated scanner model (24).

2. Computer-implemented method according to claim 1, wherein the configuration (25) for MRI comprises respective values for one or more parameters specifying a data acquisition by the MRI scanner (1).

3. Computer-implemented method according to claim 2, wherein the one or more parameters specifying the data acquisition comprises

   - one or more currents for active shimming; and/or
   - one or more parameters defining an application of an RF-pulse; and/or
   - one or more parameters defining a k-space sampling scheme.

4. Computer-implemented method according to one of the preceding claims, wherein the configuration (25) for MRI comprises data specifying an MRI image reconstruction.

5. Computer-implemented method according to claim 4, wherein the data specifying an MRI image reconstruction comprises

   - a correction map for diffusion imaging;
   - bias field correction data; and/or

- undistortion data for compensating a potential geometric image distortion.

6. Computer-implemented method according to one of the preceding claims, wherein a sequence description of an MRI sequence corresponding to the MRI measurement data (23) is received and the first input data (22, 23) depends on the sequence description.

7. Computer-implemented method according to one of the preceding claims, wherein

   - the first MLM (20) comprises an MRI data encoder module (28) and applying the trained first MLM (20) to the first input data (22, 23) comprises applying the MRI data encoder module (28) to the MRI measurement data (23) to generate encoded MRI measurement data;
   - the first MLM (20) comprises a model encoder module (27) and applying the trained first MLM (20) to the first input data (22, 23) comprises applying the model encoder module (27) to the initial scanner model (22) to generate encoded model data;
   - fused data is generated by fusing at least the encoded MRI measurement data and the encoded model data; and
   - the first MLM (20) comprises a model decoder module (31) and the first updated scanner model (24) is generated by applying the model decoder module (31) to the fused data.

8. Computer-implemented method according to one of the preceding claims, wherein

   - a second updated scanner model (26) is generated depending on the first updated scanner model (24) and/or depending on the initial scanner model (22) by using an estimation model for predicting a temporal state change of the MRI scanner (1); and
   - the configuration (25) for MRI or a further configuration (25') for MRI is determined depending on the second updated scanner model (26).

9. Computer-implemented method according to claim 8, wherein using the estimation model comprises applying a trained second MLM (21) to second input data, which depends on the first updated scanner model (24) and/or the initial scanner model (22) .

10. Computer-implemented method according to claim 9, wherein

   - the trained second MLM (21) comprises a convolutional neural network, CNN; or
   - the trained second MLM (21) comprises a neural ordinary differential equation network.

11. Computer-implemented method according to one of the preceding claims, wherein

   - a patient model specifying body properties of a patient or a patient population is received; and
   - the first input data (22, 23) depends on the patient model.

12. Computer-implemented method according to one of the preceding claims, wherein the MRI measurement data (23) comprises patient adjustment scan data and/or patient diagnostic scan data and/or phantom calibration scan data.

13. Method for MRI of an object (6), wherein a computer-implemented method according to one of the preceding claims is carried out,

   - the MRI scanner (1) is configured according to the determined configuration (25) for MRI, further MRI measurement data (23) representing the object (6) is generated by using the configured MRI scanner (1), and an MRI image of the object (6) is reconstructed based on the further MRI measurement data (23); or
   - further MRI measurement data (23) representing the object (6) is generated by using the MRI scanner (1), and an MRI image of the object (6) is reconstructed based on the further MRI measurement data (23) according to the determined configuration (25) for MRI.

14. Computer-implemented training method for training a first MLM (20) for use in a computer-implemented method according to one of the claims 1 to 12, wherein

   - an initial scanner training model for the MRI scanner (1) is received, the initial training scanner model specifying a deviation of a main magnetic field from a predefined target main magnetic field and/or a specifying a deviation of a magnetic field gradient from a predefined target gradient field;
- a perturbed scanner model is generated by adding a perturbation to the initial scanner training model;
- MRI training data measured by using the MRI scanner (1) or obtained by simulating a measurement of the MRI scanner (1) is received;
- a reconstructed scanner model is generated by applying the first MLM (20) to first input training data, which depends on the perturbed scanner model and the MRI training data; and
- the first MLM (20) is updated depending on a value of a predefined loss function, which depends on the initial scanner training model and the reconstructed scanner model.

**15.** Data processing apparatus comprising

- at least one computing unit (14), which is adapted to carry out a computer-implemented method according to one of claims 1 to 12; and/or
- at least one further computing unit, which is adapted to carry out a computer-implemented training method according to claim 14.

**16.** Computer program product comprising

- instructions, which, when carried out by a data processing apparatus, cause the data processing apparatus to carry out a computer-implemented method according to one of claims 1 to 12; and/or
- further instructions, which, when carried out by a further data processing apparatus, cause the further data processing apparatus to carry out a computer-implemented training method according to claim 14.

FIG 1

FIG 2

FIG 3

FIG 4

FIG 5

FIG 6

FIG 7

FIG 8

Europäisches
Patentamt

European
Patent Office

Office européen
des brevets

# EUROPEAN SEARCH REPORT

**Application Number**

EP 24 15 9015

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | STANISLAV MOTYKA ET AL: "Predicting dynamic, motion-related changes in B0 field in the brain at a 7T MRI using a subject-specific fine-trained U-net", MAGNETIC RESONANCE IN MEDICINE, WILEY-LISS, US, vol. 91, no. 5, 9 January 2024 (2024-01-09), pages 2044-2056, XP072605281, ISSN: 0740-3194, DOI: 10.1002/MRM.29980 * the whole document * | 1-16 | INV. G01R33/54 G01R33/565 G06N3/02 |
| X | EP 4 027 161 A1 (KONINKLIJKE PHILIPS NV [NL]) 13 July 2022 (2022-07-13) * the whole document * | 1-6, 8-13,15, 16 | |
| A | EP 3 926 355 A1 (KONINKLIJKE PHILIPS NV [NL]) 22 December 2021 (2021-12-22) * the whole document * | 1-16 | |
| A | WO 2020/009282 A1 (UNIV GACHON IND ACAD COOP FOUND [KR]; GIL MEDICAL CT [KR]) 9 January 2020 (2020-01-09) * the whole document * | 1-16 | **TECHNICAL FIELDS SEARCHED (IPC)**<br>G01R<br>G06N |
| A | US 11 354 833 B2 (SIEMENS HEALTHCARE GMBH [DE]) 7 June 2022 (2022-06-07) * the whole document * | 1-16 | |

The present search report has been drawn up for all claims

| Place of search | Date of completion of the search | Examiner |
|---|---|---|
| Munich | 6 September 2024 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 607 227 A1

Application Number

EP 24 15 9015

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

| | | | |
|---|---|---|---|
| | Europäisches Patentamt<br>European Patent Office<br>Office européen des brevets | **LACK OF UNITY OF INVENTION**<br>**SHEET B** | **Application Number**<br>EP 24 15 9015 |

The Search Division considers that the present European patent application does not comply with the requirements of unity of invention and relates to several inventions or groups of inventions, namely:

    1. claims: 1-16(partially)

        Methods taking into account main magnetic field deviation
                        - - -


    2. claims: 1-16(partially)

        Methods taking into account magnetic field gradient
        deviation
                        - - -

## ANNEX TO THE EUROPEAN SEARCH REPORT
## ON EUROPEAN PATENT APPLICATION NO.

EP 24 15 9015

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2024

| Patent document cited in search report | | Publication date | Patent family member(s) | | Publication date |
|---|---|---|---|---|---|
| EP 4027161 | A1 | 13-07-2022 | CN | 116685857 A | 01-09-2023 |
| | | | DE | 112021006783 T5 | 09-11-2023 |
| | | | EP | 4027161 A1 | 13-07-2022 |
| | | | US | 2024118360 A1 | 11-04-2024 |
| | | | WO | 2022148697 A1 | 14-07-2022 |
| EP 3926355 | A1 | 22-12-2021 | CN | 115943318 A | 07-04-2023 |
| | | | EP | 3926355 A1 | 22-12-2021 |
| | | | EP | 4165425 A1 | 19-04-2023 |
| | | | JP | 2023529975 A | 12-07-2023 |
| | | | US | 2023280429 A1 | 07-09-2023 |
| | | | WO | 2021254861 A1 | 23-12-2021 |
| WO 2020009282 | A1 | 09-01-2020 | KR | 20200004079 A | 13-01-2020 |
| | | | WO | 2020009282 A1 | 09-01-2020 |
| US 11354833 | B2 | 07-06-2022 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **O. RONNEBERGER et al.** U-Net: Convolutional Networks for Biomedical Image Segmentation. *arXiv:1505.04597*
- **K. HE et al.** Deep Residual Learning for Image Recognition. *Proceedings of the IEEE Conference on Computer Vision and Pattern Recognition (CVPR)*, 2016, 770-778
- **R. ROMBACH et al.** High-resolution image synthesis with latent diffusion models.. *Proceedings of the IEEE/CVF conference on computer vision and pattern recognition*, 2022
- **A. RADFORD et al.** Learning transferable visual models from natural language supervision. *International conference on machine learning, PMLR*, 2021

- **R. CHEN et al.** Neural ordinary differential equations. *Advances in neural information processing systems*, 2018, vol. 31
- **K. O'BRIEN et al.** 3-D Residual Eddy Current Field Characterisation: Applied to Diffusion Weighted Magnetic Resonance Imaging. *IEEE Transactions on Medical Imaging*, vol. 32 (8), 1515-1525
- **N. G. LEE et al.** MaxGIRF: Image reconstruction incorporating concomitant field and gradient impulse response function effects. *Magnetic Resonance in Medicine*, vol. 88 (2), 691-710